(19) **Europäisches Patentamt / European Patent Office / Office européen des brevets**

(11) **EP 4 202 471 B1**

(12) **FASCICULE DE BREVET EUROPEEN**

(45) Date de publication et mention de la délivrance du brevet:
**10.07.2024 Bulletin 2024/28**

(21) Numéro de dépôt: **22215030.2**

(22) Date de dépôt: **20.12.2022**

(51) Classification Internationale des Brevets (IPC):
**G01S 7/02** *(2006.01)* **G01S 7/35** *(2006.01)*
**G01S 7/41** *(2006.01)* **G01S 13/04** *(2006.01)*
**G01S 13/88** *(2006.01)* **G01R 29/06** *(2006.01)*

(52) Classification Coopérative des Brevets (CPC):
**G01S 7/02; G01R 29/0814; G01S 7/354;
G01S 7/414; G01S 13/04; G01S 13/887**

(54) **PROCÉDÉ ET SYSTÈME DE DÉTECTION D'APPAREILS ÉLECTRONIQUES**

**VERFAHREN UND SYSTEM ZUR ERKENNUNG ELEKTRONISCHER GERÄTE**

**METHOD AND SYSTEM FOR DETECTING ELECTRONIC DEVICES**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **23.12.2021 FR 2114354**

(43) Date de publication de la demande:
**28.06.2023 Bulletin 2023/26**

(73) Titulaires:
- **THALES**
  **92190 Meudon (FR)**
- **Centre National de la Recherche Scientifique**
  **75016 Paris (FR)**
- **UNIVERSITE DE MONTPELLIER**
  **34090 Montpellier (FR)**

(72) Inventeurs:
- **MARTORELL, Alexandre**
  **92622 Gennevilliers Cedex (FR)**
- **GREZES, Alain**
  **92622 Gennevilliers Cedex (FR)**
- **BERTAUX, Thomas**
  **92622 Gennevilliers Cedex (FR)**
- **PICON, Thomas**
  **92622 Gennevilliers Cedex (FR)**
- **RAOULT, Jérémy**
  **34090 MONTPELLIER (FR)**

(74) Mandataire: **Atout PI Laplace**
**Immeuble Up On**
**25 Boulevard Romain Rolland**
**CS 40072**
**75685 Paris Cedex 14 (FR)**

(56) Documents cités:
**US-A1- 2015 253 415**

- **RAOULT JEREMY ET AL: "Intermodulation Radar for RF Receiver Detections", 2018 15TH EUROPEAN RADAR CONFERENCE (EURAD), EUROPEAN MICROWAVE ASSOCIATION, 26 September 2018 (2018-09-26), pages 273 - 276, XP033453475, DOI: 10.23919/EURAD.2018.8546626**
- **MARTORELL ALEXANDRE ET AL: "Compact Intermodulation Radar for Finding RF Receivers", 2019 16TH EUROPEAN RADAR CONFERENCE (EURAD), EUMA, 2 October 2019 (2019-10-02), pages 109 - 112, XP033663855**

**Description**

L'invention se situe dans le domaine de la détection électromagnétique, et plus particulièrement dans celui des RADARs non-linéaires, et plus particulièrement encore des RADARs à intermodulation.

Les appareils électroniques, et notamment les systèmes radiofréquences (RF) et hyperfréquences (MW de l'anglais « Microwaves ») sont difficiles à détecter par un RADAR linéaire conventionnel qui mesure la puissance d'une onde électromagnétique rétrodiffusée par une cible à la même fréquence que celle qui a été émise. Ces dispositifs électroniques ciblés étant de petites tailles, leur Surface Equivalente RADAR (SER) les rend extrêmement difficiles à détecter. Or, ils présentent intrinsèquement une réponse non-linéaire. Il est donc possible d'illuminer une telle cible pour ensuite exploiter les fréquences non-linéaires générées par elle : on parle de « RADAR non-linéaire ».

Le RADAR non-linéaire le plus couramment utilisé implique la génération de l'harmonique d'ordre deux (H2) d'un signal radiofréquence ou hyperfréquence émis par un appareil électronique cible. Quelle que soit l'efficacité de la génération de l'harmonique H2, cependant, elle n'est généralement pas incluse dans la bande passante de fonctionnement de la cible. Il en résulte une forte atténuation du signal réémis. Par exemple, soit l'onde incidente soit l'onde réémise se trouvera vraisemblablement en dehors de la bande passante de l'antenne de l'appareil cible, et le couplage devra alors se faire, avec une efficacité bien moindre, à travers des interstices dans le blindage et sur les pistes des circuits imprimés. Aussi, pour obtenir détecter un signal d'harmonique deux suffisamment intense il est nécessaire d'émettre des signaux de puissance très élevée, typiquement dépassant les 50 dBm.

Les RADARs à intermodulation permettent de surmonter en partie cette difficulté en utilisant deux signaux émis de fréquences $f_1$, $f_2$ proches (écart fréquentiel typiquement de quelques MHz) et en détectant les produits d'intermodulation d'ordre 3, aux fréquences $f_{IM3L}=2f_1-f_2$ et $f_{IM3H}=2f_2-f_1$. Par exemple, en choisissant $f_1$=400 MHz et $f_2$=401 MHz on obtient $f_{IM3L}$=399 MHz et $f_{IM3H}$=402 MHz - les quatre signaux peuvent donc être à l'intérieur de la bande passante de l'antenne de l'appareil à détecter.

Des RADARs à intermodulation sont connus par exemple des brevets EP 0 309 350 et US 9,395,434 (correspondant à la demande US 2015/0253415) et des articles (Martorell 2018) et (Martorell 2019).

Il est également connu d'identifier l'appareil électronique détecté à partir de la variation du niveau de puissance du signal d'intermodulation en fonction de la puissance des signaux émis (US 9,395,434) ou de leur fréquence (Martorell 2018).

Malgré l'amélioration du couplage des signaux non-linéaires permise par l'utilisation de la technique de l'intermodulation, le niveau de ces signaux reste très faible, ce qui constitue un obstacle à la détection et encore plus à l'identification des cibles.

L'invention vise à surmonter au moins en partie les inconvénients précités de l'art antérieur. Plus particulièrement elle vise à améliorer le rendement de génération des signaux d'intermodulation et, par conséquent, à augmenter le niveau de puissance des signaux reçus par un RADAR non-linéaire, facilitant ainsi la détection et, de préférence, l'identification d'appareils électroniques.

Conformément à l'invention, ce but est atteint en émettant deux signaux électromagnétiques radiofréquences ou hyperfréquences à des niveaux de puissance différents, alors que dans l'art antérieur deux signaux de même puissance sont émis par un RADAR à intermodulation. Les inventeurs se sont en effet rendu compte que cela permet d'augmenter significativement le niveau de puissance d'un signal d'intermodulation. Plus précisément, si $f_1$<$f_2$, augmenter le niveau de puissance du premier signal de fréquence $f_1$ par rapport à celui du second signal de fréquence $f_2$ permet d'augmenter le niveau de puissance du signal d'intermodulation à la fréquence $f_{IM3L}=2f_1-f_2$. Réciproquement, augmenter le niveau de puissance du second signal de fréquence $f_2$ par rapport à celui du premier signal de fréquence $f_1$ permet d'augmenter le niveau de puissance du signal d'intermodulation à la fréquence $f_{IM3H}=2f_2-f_1>f_{IM3L}$. Par ailleurs, l'écart de puissance $\Delta$ entre les deux signaux émis qui maximise le niveau de puissance d'un signal d'intermodulation reçu constitue une signature de l'appareil électronique détecté, permettant ou facilitant son identification.

Un objet de l'invention est donc un procédé de détection d'appareils électroniques comprenant les étapes consistant à :

a) émettre simultanément vers une même région d'intérêt un premier signal électromagnétique à une première fréquence f1 dans le domaine radio- ou hyperfréquence et un second signal électromagnétique à une seconde fréquence f2 également dans le domaine radio- ou hyperfréquence et supérieure à la première fréquence f1 ; et
b) recevoir un signal électromagnétique réémis par au moins un appareil électronique à détecter situé dans la région d'intérêt, correspondant à un produit d'intermodulation du premier et du second signal électromagnétique ;

caractérisé en ce que le premier et le second signal électromagnétique présentent, dans la région d'intérêt, des niveaux de puissance différents, présentant un écart d'au moins 10 dB.

Selon des modes de réalisation particuliers de l'invention :

- Le premier signal électromagnétique peut présenter, dans la région d'intérêt, un niveau de puissance supérieur à celui du second signal électromagnétique, et dans lequel le signal électromagnétique reçu présente une fréquence fIM3L=2f1-f2.

- Le premier signal électromagnétique peut présenter, dans la région d'intérêt, un niveau de puissance inférieur à celui du second signal électromagnétique, et le signal électromagnétique reçu peut alors présenter une fréquence fIM3H=2f2-f1.

- L'étape a) peut comprendre un balayage de la première et de la seconde fréquence, maintenant un écart fréquentiel fixe entre elles. Le procédé peut alors comprendre également une étape c) d'identification du ou d'un appareil électronique dans la région d'intérêt en fonction d'une variation du niveau de puissance du signal reçu au cours du balayage de la première et de la seconde fréquence.

- L'étape a) peut comprendre une variation de l'écart de niveau de puissance entre le premier et le second signal électromagnétique. Le procédé peut alors comprendre également une étape c') d'identification du ou d'un appareil électronique dans la région d'intérêt en fonction d'une variation du niveau de puissance du signal reçu avec l'écart de niveau de puissance entre le premier et le second signal électromagnétique.

- En variante, les niveaux de puissance du premier et du second signal électromagnétique et leurs fréquences sont fixés à des valeurs maximisant le niveau de puissance du signal réémis par un appareil électronique d'un type prédéfini et correspondant à un produit d'intermodulation du premier et du second signal électromagnétique.

Un autre objet de l'invention est un système de détection d'appareils électroniques comprenant :

- au moins un émetteur pour émettre simultanément vers une même région d'intérêt un premier signal électromagnétique à une première fréquence f1 dans le domaine radio- ou hyperfréquence et un second signal électromagnétique à une seconde fréquence f2 également dans le domaine radio- ou hyperfréquence et supérieure à la première fréquence f1 ;
- au moins un récepteur pour recevoir un signal électromagnétique réémis par au moins un appareil électronique à détecter situé dans la région d'intérêt, correspondant à un produit d'intermodulation du premier et du second signal électromagnétique ;

caractérisé en ce que l'émetteur est configuré pour émettre le premier et le second signal électromagnétiques de telle sorte qu'ils présentent, dans la région d'intérêt, des niveaux de puissance différents, avec un écart d'au moins 10 dB.

Un tel système peut comprendre également un contrôleur configuré pour contrôler l'émetteur de manière à varier l'écart de niveau de puissance entre le premier et le second signal électromagnétique, et un processeur configuré pour identifier ledit ou au moins un dit appareil électronique dans la région d'intérêt en fonction d'une variation du niveau de puissance du signal reçu avec l'écart de niveau de puissance entre le premier et le second signal électromagnétique.

D'autres caractéristiques, détails et avantages de l'invention ressortiront à la lecture de la description faite en référence aux dessins annexés donnés à titre d'exemple et qui représentent, respectivement :

[Fig.1] un synoptique d'un système selon un mode de réalisation de l'invention ;

[Fig. 2], un graphique illustrant les niveaux de puissance des signaux électromagnétiques émis dans un procédé selon un mode de réalisation de l'invention ;

[Fig. 3], un graphique illustrant les niveaux de puissance des signaux électromagnétiques émis et reçus dans un procédé selon un mode de réalisation de l'invention ;

[Fig. 4], un graphique illustrant l'augmentation de puissance du signal reçu obtenue pour différents niveaux de puissance du premier et second signal électromagnétique émis, par rapport à l'art antérieur et pour un appareil électronique d'un premier type ;

[Fig. 5], un graphique illustrant l'augmentation de puissance du signal reçu obtenue pour différents niveaux de puissance du premier et second signal électromagnétique émis, par rapport à l'art antérieur et pour un appareil électronique d'un deuxième type ;

[Fig. 6], un graphique illustrant comment l'écart signal à bruit du signal reçu varie en fonction de la distance entre l'émetteur et l'appareil électronique cible, pour différents niveaux de puissance du premier et second signal électromagnétique émis ; et

[Fig. 7], un graphique illustrant comment l'augmentation de puissance du signal reçu par rapport à l'art antérieur varie en fonction de la distance entre l'émetteur et l'appareil électronique cible, pour différents niveaux de puissance du premier et second signal électromagnétique émis.

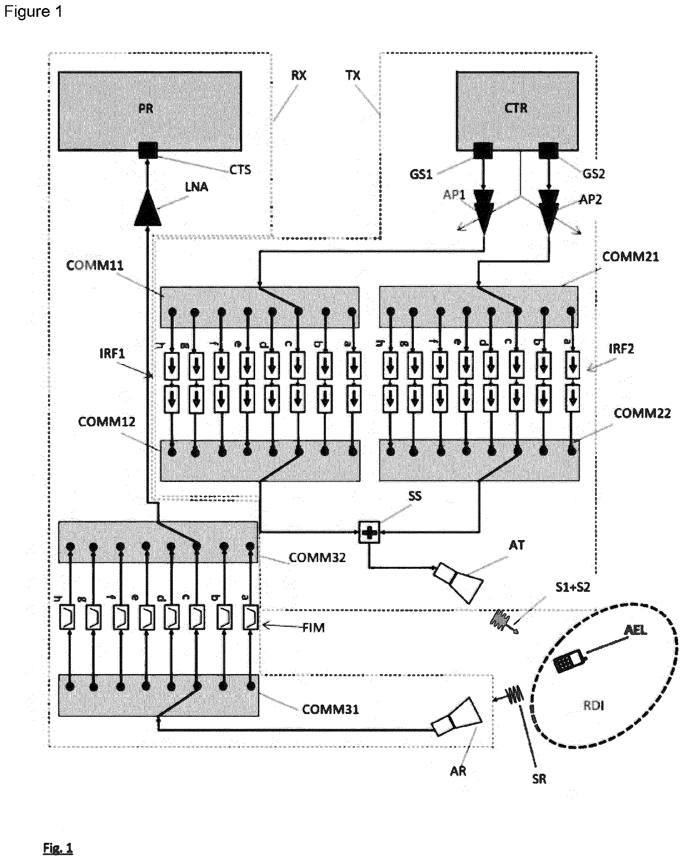

Comme illustré sur la [Fig. 1], un appareil selon un mode de réalisation de l'invention comprend un émetteur TX et un récepteur RX.

L'émetteur TX comprend un premier générateur de signaux radio- ou hyperfréquence GS1 pouvant générer un premier signal S1 à une fréquence $f_1$ comprise, dans le mode de réalisation de la [Fig. 1], entre 380 MHz et 6 GHz, ainsi qu'un second générateur de signaux radio- ou hyperfréquence GS2 pouvant générer un second signal S2 à une fréquence $f_2$ différente de $f_1$ mais comprise dans la même plage fréquentielle que $f_1$. Les générateurs de signaux peuvent par exemple être de type « radio logicielle », et générer les signaux S1, S2 numériquement. Dans la suite on suppose $f_1 < f_2$.

L'émetteur TX comprend également un premier amplificateur de puissance AP1 pour amplifier le premier signal S1 et un second amplificateur de puissance AP2 pour amplifier le second signal S2.

Un contrôleur CTR, par exemple basé sur un microprocesseur ou un circuit numérique de type FPGA ou ASIC, pilote les générateurs de signaux GS1, GS2 pour fixer les valeurs des fréquences $f_1$ et $f_2$ ; avantageusement, il est configuré ou programmé pour pouvoir varier ces valeurs tout en maintenant constant leur écart. Le contrôleur CTR pilote également les amplificateurs AP1, AP2 pour fixer les niveaux de puissance $P_{f1}$, $P_{f2}$ des signaux S1, S2, respectivement, avec un écart $\Delta$ (en dB) - fixe ou variable - entre eux. Avantageusement, le contrôleur est configuré ou programmé pour pouvoir varier les valeurs de $P_{f1}$, $P_{f2}$ et $\Delta$ de manière contrôlée. Les niveaux de puissance des signaux S1, S2 amplifiés peuvent par exemple atteindre les 10 W et le gain des amplificateurs AP1, AP2 les 70 dB. Avantageusement ces amplificateurs opèrent en régime linéaire pour limiter le bruit d'émission.

Des bancs d'isolateurs radiofréquences IRF1, IRF2 sont agencés sur les trajets des signaux S1, S2 amplifiés. Les isolateurs présentent une bande de fonctionnement limitée, des commutateurs mécaniques COMM11, COMM12, COMM21, COMM22 permettent de sélectionner le bon isolateur dans la bande de fonctionnement voulue pour chacun des deux signaux S1, S2 en fonction de sa fréquence. Dans l'exemple de la [Fig. 1] les isolateurs des bancs IRF1, IRF2 sont désignés par une lettre de a. à h. en fonction de leur bande de fonctionnement :

a. [380 MHz - 650 MHz]
b. [650 MHz - 1000 MHz]
c. [1000 MHz - 1400 MHz]
d. [1400 MHz - 2000 MHz]
e. [2000 MHz - 2500 MHz]
f. [2500 MHz - 3400 MHz]
g. [3400 MHz - 4500 MHz]
h. [4500 MHz - 6000 MHz]

La fonction des isolateurs est d'éviter qu'une composante réfléchie du signal S1 pénètre dans l'amplificateur AP2, et réciproquement qu'une composante réfléchie du signal S12 pénètre dans l'amplificateur AP1, engendrant des produits d'intermodulation parasites qui seraient rayonnées, réfléchis et captés par le récepteur RX perturbant la détection d'un appareil électronique.

Un combineur de signaux large bande SS combine les signaux S1 et S2 pour les fournir en entrée d'une antenne, également large bande (par exemple de type cornet) qui les rayonne vers une région d'intérêt RDI - typiquement située à une distance de quelques mètres - qui peut contenir un appareil électronique AEL à détecter.

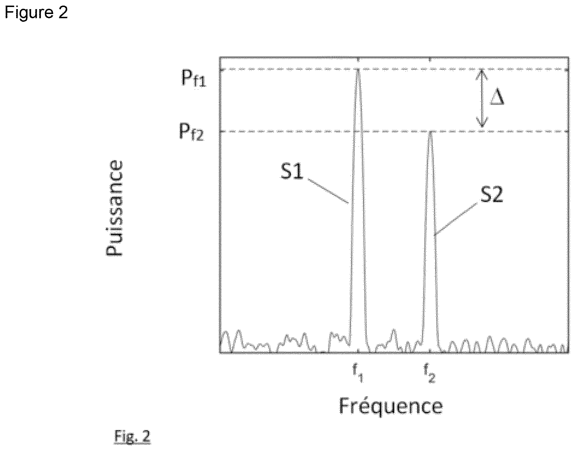

La [Fig. 2] montre le spectre de puissance d'un tel signal émis. On remarque les deux composantes de puissance $P_{f1}$ et $P_{f2}$ correspondant aux signaux S1 et S2, et l'écart $\Delta$ entre leurs niveaux de puissance.

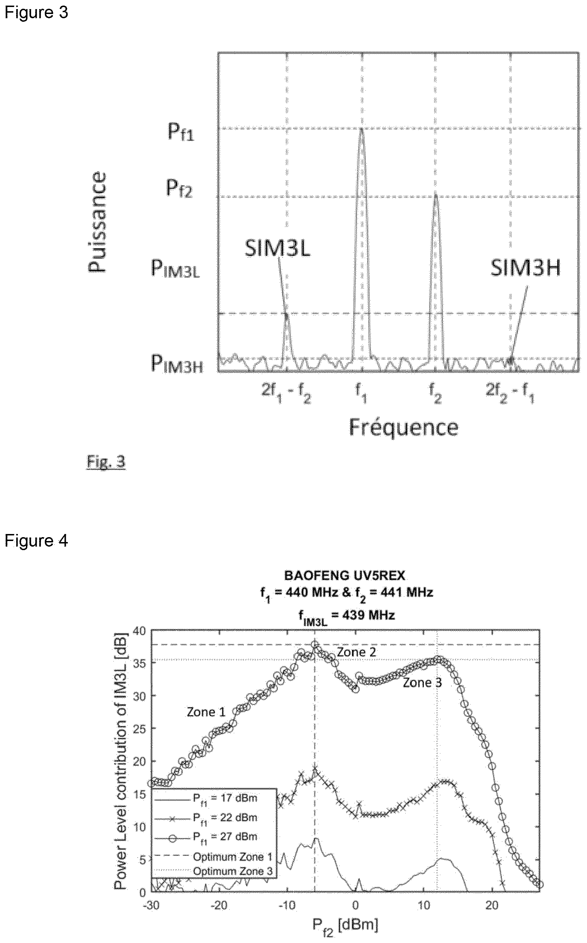

Un appareil électronique AEL situé dans la région d'intérêt RDI et présentant une bande de fonctionnement qui inclut $f_1$ et $f_2$ réémet un signal SR comprenant des composantes d'intermodulations aux fréquences $f_{IM3L}=2f_1-f_2$ et $f_{IM3H}=2f_2-f_1$. La [Fig. 3) montre le spectre de puissance d'un tel signal réémis. On remarque, en plus de deux composantes - dominantes - aux fréquences fondamentales $f_1$, $f_2$, un produit d'intermodulation SIM3L à la fréquence $f_{IM3L}$ (la composante SIM3H à la fréquence $f_{IM3H}$ est noyée dans le bruit de fond).

Le signal SR est capté par une antenne AR large bande, par exemple de type cornet, du récepteur RX, puis dirigé vers un banc de filtres FIM. Deux commutateurs mécaniques COMM31, COMM32 permettent de sélectionner un filtre du banc en fonction de la bande de fonctionnement sélectionnée en émission. Dans l'exemple de la [Fig. 1] les filtres du banc FIM sont désignés par une lettre de a. à h. en fonction de leur bande de fonctionnement, comme les isolateurs. Ces filtres sont du type passe-bande et ont pour fonction de sélectionner le produit d'intermodulation d'intérêt (SIM3L dans l'exemple de la Fig. 1) en rejetant les fréquences fondamentales. Le signal reçu et filtré est ensuite traité par un circuit de traitement de signal CTS, qui par exemple le convertit au format numérique. Un processeur PR pilote l'acquisition du signal numérisé en synchronie avec le contrôleur CTR et l'analyse pour détecter et éventuellement identifier un ou plusieurs appareils électroniques AEL dans la région d'intérêt. Comme le contrôleur CTR, le processeur PR peut être, par exemple, basé sur un microprocesseur ou un circuit numérique de type FPGA ou ASIC.

Pour tester l'invention, deux appareils électroniques cibles ont été placés dans le champ de détection (région d'intérêt RDI) de l'appareil de la [Fig. 1], à une distance de 2m de l'antenne d'émission et de l'antenne de réception, pour être testés successivement : un Talkie-Walkie de référence BAOFENG UV5REX et un modem GSM de référence TELIC TE-910-G. Des balayages puissances ont été réalisé, dans lequel le niveau de puissance $P_{f2}$ du signal S2 a été varié de manière continue, tout en maintenant constant le niveau de puissance $P_{f1}$ du signal S1. Ces balayages ont été répétés pour trois niveaux de puissance du signal $P_{f1}$ : 17 dBm, 22 dBm et 27 dBm.

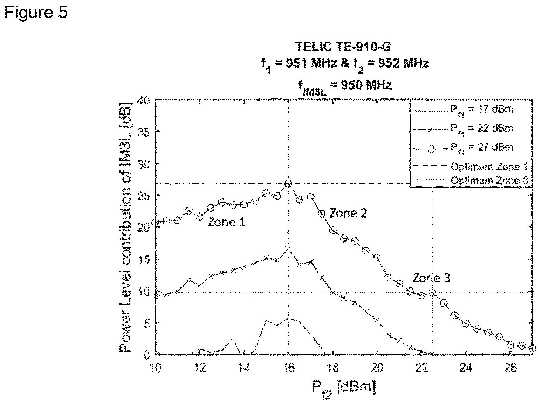

Les [Fig. 4] et [Fig. 5] montrent, pour le premier et le deuxième appareil électronique cible, respectivement, le niveau de contribution (c'est-à-dire le gain en niveau de puissance du signal SIM3L, exprimé en dB) obtenu conformément à l'invention - en prenant $P_{f2} \neq P_{f1}$ - par rapport au cas connu de l'art antérieur où

$$P_{f2} = P_{f1}.$$

On remarque que, dans la limite des faibles valeurs de $P_{f2}$ (Zone 1 relatant d'un état de la cible faiblement non-linéaire) le niveau de contribution augmente avec $P_{f2}$ jusqu'à atteindre un maximum. Ceci s'explique par deux phénomènes :

Par le fait que dans le cas de l'art antérieur, dans la zone 1, l'amplitude du signal SIM3L est en deçà du niveau de bruit

En observant que l'amplitude du signal SIM3L est donnée par :

$$V_{IM3L} = \frac{3}{4} a_3 V_1{}^2 V_2$$

Où $V_1$, $V_2$ sont les amplitudes des signaux $S_1$ et $S_2$, respectivement.

En passant à la puissance, $P_{IM3L}$, et en exprimant la valeur en dBm on voit que la dépendance se fait linéairement (en dB) de $P_{f2}$ en suivant une pente 1dB/dB.

On remarque que, dans la limite des faibles valeurs de $P_{f2}$ (Zone 2 relatant d'un état de la cible faiblement non-linéaire) le niveau de contribution augmente avec $P_{f2}$ à un taux de -2dB/dB. Ceci s'explique en observant que l'amplitude du signal SIM3L est donnée par :

$$V_{IM3L} = \frac{3}{4} a_3 V_1{}^2 V_2$$

Où $V_1$, $V_2$ sont les amplitudes des signaux $S_1$ et $S_2$, respectivement. Dans le cas de l'art antérieur où $V_1 = V_2$ on peut écrire

$$V'_{IM3L} = \frac{3}{4} a_3 V_2{}^3$$

Et donc

$$\frac{V_{IM3L}}{V'_{IM3L}} = \frac{V_1{}^2}{V_2{}^2}$$

En passant aux puissances, $P_{IM3L}$, $P'_{IM3L}$ et en exprimant les valeurs en dBm on voit que le rapport $P_{IM3L}/P'_{IM3L}$ dépend linéairement (en dB) de $P_{f2}$.

Pour des valeurs de $P_{f2}$ excédant un seuil qui dépend de l'appareil électronique détecté (Zone 3 relatant d'un état de la cible fortement non-linéaire), des effets de saturation modifient cette relation simple et des maxima apparaissent (un dans la [Fig. 4] ; un dans la [Fig. 5]). On rappelle que les graphiques montrent la contribution au niveau de puissance du signal SIM3L, et non le niveau de puissance lui-même ; aussi sur la [Fig. 4] et la [Fig. 5], le maximum de gauche correspond à une contribution importante pour la détection, par rapport à un niveau de signal faible. Aussi sur la [Fig. 4] et la [Fig. 5], seul le maximum de droite présente un véritable intérêt d'identification.

Les contributions optimales pour les deux cibles sont données par :

[Table 1]

| Contributions Optimales de détection | | | BAOFENG UV5REX Contribution sur IM3L | TELIC TE-910-G Contribution sur IM3L |
|---|---|---|---|---|
| $P_{f1}$ | $P_{f2}$ | $\Delta = P_{f1}-P_{f2}$ | | |
| 12 dBm + 15 dB | 12 dBm | 15 dB | 35.4 dB | - |
| 16 dBm + 11 dB | 16 dBm | 11 dB | - | 26.84 dB |

On constate que l'utilisation de niveaux de puissance différents pour les deux signaux émis permet d'obtenir un gain important, de plus de 26 dB à plus de 35 dB, en fonction de la cible. Bien que cela soit préférable, il n'est pas nécessaire de choisir exactement la valeur optimale de $\Delta$ : d'une manière générale, l'utilisation d'un écart de puissance d'au moins 10 dB s'avère avantageux.

On remarque également que l'optimum de contribution de la zone 3 dépend de la cible et peut donc servir de critère d'identification de cette dernière.

Si la cible à détecter est connue, il est possible d'utiliser une configuration optimale de l'appareil de la [Fig. 1], en choisissant des fréquences $f_1$, $f_2$ au centre de la bande de fonctionnement de la cible et des valeurs optimales de $P_{f1}$ et $\Delta$. Si par contre la cible n'est pas connue, ou est connue de manière imparfaite, il est possible de procéder à un balayage de la valeur de l'écart $\Delta$ et identifier l'appareil électronique cible en observant comment le niveau de puissance $P_{IM3L}$ varie. En variante ou en complément, il est possible d'identifier la cible en effectuant un balayage de la première et de la seconde fréquence, maintenant un écart fréquentiel fixe entre elles, et observant comment le niveau de puissance $P_{IM3L}$ varie. Lors du balayage, la valeur d'écart de puissance $\Delta$ ne sera pas forcément optimal, mais il pourra être optimisé une fois la cible identifiée.

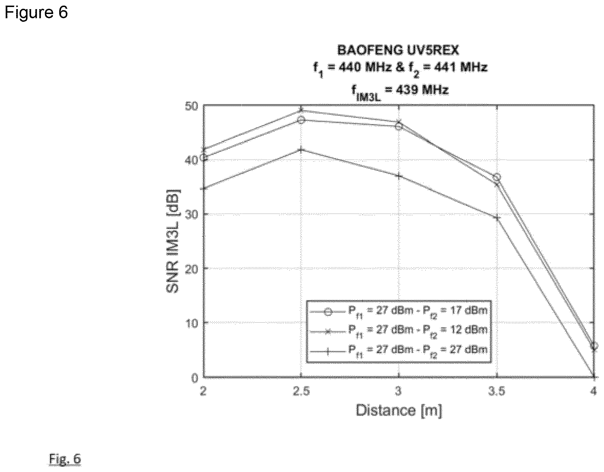

La [Fig. 6] est un graphique de l'écart signal à bruit SNR du signal SIM3L issu du Talkie-Walkie de référence BAOFENG UV5REX en fonction de la distance cible - antenne, pour $P_{f1}$=27 dBm et trois valeurs de $\Delta$ : $\Delta$=15 dB ; $\Delta$=12 dB (contributions optimales de détection) et $\Delta$=0 (art antérieur). On remarque que l'invention permet de gagner jusqu'à 10 dB de SNR par rapport à l'art antérieur ; les performances ne sont que légèrement dégradées si la valeur de $\Delta$ s'écarte de 3dB de l'optimum.

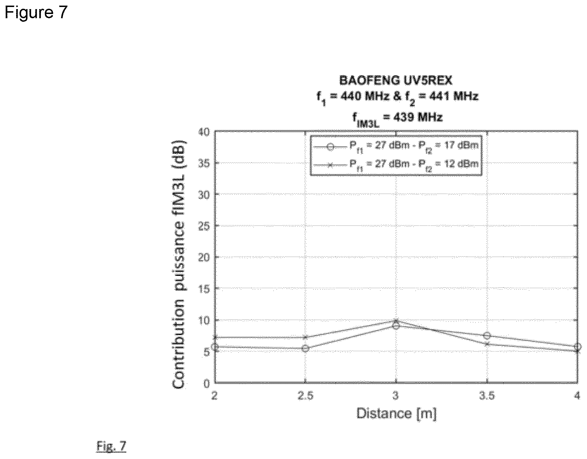

La [Fig. 7] est un graphique de la contribution au signal SIM3L issu du Talkie-Walkie de référence BAOFENG UV5REX en fonction de la distance cible - antenne, pour $P_{f1}$=27 dBm et deux valeurs de $\Delta$ : $\Delta$=15 dB ; $\Delta$=12 dB. Là aussi on constate, plus clairement, cette contribution qui peut atteindre 10 dB et une faible dégradation des performances si la valeur de $\Delta$ s'écarte de 3dB de l'optimum.

L'invention a été décrite en référence à un mode de réalisation particulier, mais des variantes sont possibles. Par exemple, il est possible de choisir $P_{f1}<P_{f2}$, auquel cas c'est le niveau de puissance du signal $S_{IM3H}$ qui sera augmenté. De même, il est possible de travailler en configuration monostatique, avec une seule antenne pour émettre et recevoir les signaux électromagnétiques ou, inversement, utiliser deux antennes émettrices distinctes pour les signaux $S_1$ et $S_2$. Par ailleurs, les valeurs de puissance et de fréquence ont été données uniquement à titre d'exemple.

Dans les exemples de réalisation décrits plus haut seul un appareil électronique détectable se trouvait, à chaque instant, dans la région d'intérêt, mais l'invention permet également la multi-détection.

Références

(Martorell 2018) : Intermodulation Radar for RF Receiver Détections, Proceedings of the 15th European Radar Conférence, 26-28 septembre 2018, Madrid, Espagne.

(Martorell 2019): Compact Intermodulation Radar for Finding RF Receivers Proceedings of the 16th European Radar Conférence, 2 - 4 octobre 2019, Paris, France.

**Revendications**

1. Procédé de détection d'appareils électroniques comprenant les étapes consistant à :

   a) émettre simultanément vers une même région d'intérêt (RDI) un premier signal électromagnétique (S1) à une première fréquence $f_1$ dans le domaine radio- ou hyperfréquence et un second signal électromagnétique (S2) à une seconde fréquence $f_2$ également dans le domaine radio- ou hyperfréquence et supérieure à la première fréquence $f_1$; et
   b) recevoir un signal électromagnétique (SR) réémis par au moins un appareil électronique (AEL) à détecter situé dans la région d'intérêt, correspondant à un produit d'intermodulation du premier et du second signal électromagnétique ;

   **caractérisé en ce que** le premier et le second signal électromagnétique présentent, dans la région d'intérêt, des niveaux de puissance différents, présentant un écart ($\Delta$) d'au moins 10 dB.

2. Procédé selon la revendication 1 dans lequel le premier signal électromagnétique (S1) présente, dans la région d'intérêt, un niveau de puissance ($P_{f1}$) supérieur à celui ($P_{f2}$) du second signal électromagnétique (S2), et dans lequel le signal électromagnétique reçu présente une fréquence $f_{IM3L}=2f_1-f_2$.

3. Procédé selon la revendication 1 dans lequel le premier signal électromagnétique présente, dans la région d'intérêt, un niveau de puissance ($P_{f1}$) inférieur à celui ($P_{f2}$) du second signal électromagnétique, et dans lequel le signal électromagnétique reçu (SR) présente une fréquence $f_{IM3H}=2f_2-f_1$.

4. Procédé selon l'une des revendications précédentes dans lequel l'étape a) comprend un balayage de la première et de la seconde fréquence, maintenant un écart fréquentiel fixe entre elles.

5. Procédé selon la revendication 4 comprenant également une étape c) d'identification du ou d'un appareil électronique (AEL) dans la région d'intérêt (RDI) en fonction d'une variation du niveau de puissance ($P_{IM3L}$, $P_{IM3H}$) du signal reçu (SR) au cours du balayage de la première et de la seconde fréquence.

6. Procédé selon l'une des revendications précédentes dans lequel l'étape a) comprend une variation de l'écart ($\Delta$) de niveau de puissance entre le premier (S1) et le second (S2) signal électromagnétique.

7. Procédé selon la revendication 6 comprenant également une étape c') d'identification du ou d'un appareil électronique (AEL) dans la région d'intérêt (RDI) en fonction d'une variation du niveau de puissance ($P_{IM3L}$, $P_{IM3H}$) du signal reçu (SR) avec l'écart ($\Delta$) de niveau de puissance entre le premier (S1) et le second (S2) signal électromagnétique.

8. Procédé selon l'une des revendications 1 à 3 dans lequel les niveaux de puissance ($P_{f1}$, $P_{f2}$) du premier (S1) et du second (S2) signal électromagnétique et leurs fréquences sont fixés à des valeurs maximisant le niveau de puissance du signal réémis par un appareil électronique (AEL) d'un type prédéfini et correspondant à un produit d'intermodulation du premier et du second signal électromagnétique.

9. Système de détection d'appareils électroniques comprenant :

   - au moins un émetteur (TX) pour émettre simultanément vers une même région d'intérêt (RDI) un premier signal électromagnétique (S1) à une première fréquence $f_1$ dans le domaine radio- ou hyperfréquence et un second signal électromagnétique (S2) à une seconde fréquence $f_2$ également dans le domaine radio- ou hyperfréquence et supérieure à la première fréquence $f_1$;
   - au moins un récepteur (RX) pour recevoir un signal électromagnétique (SR) réémis par au moins un appareil électronique (AEL) à détecter situé dans la région d'intérêt, correspondant à un produit d'intermodulation du premier et du second signal électromagnétique ;

   **caractérisé en ce que** l'émetteur est configuré pour émettre le premier et le second signal électromagnétiques de telle sorte qu'ils présentent, dans la région d'intérêt, des niveaux de puissance différents, avec un écart ($\Delta$) d'au moins 10 dB.

10. Système selon la revendication 9 comprenant également un contrôleur (CTR) configuré pour contrôler l'émetteur (TX) de manière à varier l'écart de niveau de puissance entre le premier et le second signal électromagnétique, et un processeur (PR) configuré pour identifier ledit ou au moins un dit appareil électronique (AEL) dans la région d'intérêt en fonction d'une variation du niveau de puissance ($P_{IM3L}$, $P_{IM3H}$) du signal reçu (SR) avec l'écart de niveau de puissance ($\Delta$) entre le premier et le second signal électromagnétique.

**Patentansprüche**

1. Verfahren zum Erkennen von elektronischen Vorrichtungen, das die folgenden Schritte umfasst:

   a) gleichzeitiges Senden eines ersten elektromagnetischen Signals (S1) mit einer ersten Frequenz $f_1$ im Radio- oder Mikrowellenbereich und eines zweiten elektromagnetischen Signals (S2) mit einer zweiten Frequenz $f_2$, die ebenfalls im Radio- oder Mikrowellenbereich liegt und höher als die erste Frequenz $f_1$ ist, zu derselben Region von Interesse (RDI); und
   b) Empfangen eines elektromagnetischen Signals (SR), das von mindestens einer zu erfassenden elektronischen Vorrichtung (AEL), die sich in der Region von Interesse befindet, erneut ausgesendet wird, das einem Intermodulationsprodukt des ersten und des zweiten elektromagnetischen Signals entspricht;

   **dadurch gekennzeichnet, dass** das erste und das zweite elektromagnetische Signal in der Region von Interesse unterschiedliche Leistungspegel aufweisen, die eine Abweichung ($\Delta$) von mindestens 10 dB aufweisen.

2. Verfahren nach Anspruch 1, wobei das erste elektromagnetische Signal (S1) in der Region von Interesse einen Leistungspegel ($P_{f1}$) aufweist, der größer ist als der ($P_{f2}$) des zweiten elektromagnetischen Signals (S2), und wobei das empfangene elektromagnetische Signal eine Frequenz $f_{IM3L} = 2f_1 - f_2$ aufweist.

3. Verfahren nach Anspruch 1, wobei das erste elektromagnetische Signal in der Region von Interesse einen Leistungspegel ($P_{f1}$) aufweist, der niedriger ist als der ($P_{f2}$) des zweiten elektromagnetischen Signals, und wobei das empfangene elektromagnetische Signal (SR) eine Frequenz $f_{IM3H} = 2f_2 - f_1$ aufweist.

4. Verfahren nach einem der vorhergehenden Ansprüche, wobei Schritt a) ein Abtasten der ersten und der zweiten Frequenz unter Beibehaltung einer festen Frequenzabweichung dazwischen umfasst.

5. Verfahren nach Anspruch 4, das auch einen Schritt c) des Identifizierens der oder einer elektronischen Vorrichtung (AEL) in der Region von Interesse (RDI) in Abhängigkeit von einer Variation des Leistungspegels ($P_{IM3L}$, $P_{IM3H}$) des empfangenen Signals (SR) während der Abtastung der ersten und der zweiten Frequenz umfasst.

6. Verfahren nach einem der vorhergehenden Ansprüche, wobei Schritt a) eine Variation der Leistungspegelabweichung ($\Delta$) zwischen dem ersten (S1) und dem zweiten (S2) elektromagnetischen Signal umfasst.

7. Verfahren nach Anspruch 6, das auch einen Schritt c') des Identifizierens der oder einer elektronischen Vorrichtung (AEL) in der Region von Interesse (RDI) in Abhängigkeit von einer Variation des Leistungspegels ($P_{IM3L}$, $P_{IM3H}$) des empfangenen Signals (SR) mit der Leistungspegelabweichung ($\Delta$) zwischen dem ersten (S1) und dem zweiten (S2) elektromagnetischen Signal umfasst.

8. Verfahren nach einem der Ansprüche 1 bis 3, wobei die Leistungspegel ($P_{f1}$, $P_{f2}$) des ersten (S1) und des zweiten (S2) elektromagnetischen Signals und ihre Frequenzen auf Werte fixiert werden, die den Leistungspegel des Signals maximieren, das von einer elektronischen Vorrichtung (AEL) eines vordefinierten Typs erneut ausgesendet wird und einem Intermodulationsprodukt des ersten und des zweiten elektromagnetischen Signals entspricht.

9. System zur Erkennung elektronischer Vorrichtungen, das Folgendes umfasst:

   - mindestens einen Sender (TX) zum gleichzeitigen Senden eines ersten elektromagnetischen Signals (S1) mit einer ersten Frequenz $f_1$ im Radio- oder Mikrowellenbereich und eines zweiten elektromagnetischen Signals (S2) mit einer zweiten Frequenz $f_2$, die ebenfalls im Radio- oder Mikrowellenbereich liegt und höher ist als die erste Frequenz $f_1$, zu derselben Region von Interesse (RDI);
   - mindestens einen Empfänger (RX) zum Empfangen eines elektromagnetischen Signals (SR), das von mindestens einer zu erfassenden elektronischen Vorrichtung (AEL), die sich in der Region von Interesse befindet, erneut ausgesendet wird, das einem Intermodulationsprodukt des ersten und des zweiten elektromagnetischen Signals entspricht;

**dadurch gekennzeichnet, dass** der Sender so konfiguriert ist, dass er das erste und das zweite elektromagnetische Signal so aussendet, dass sie in der Region von Interesse unterschiedliche Leistungspegel mit einer Abweichung ($\Delta$) von mindestens 10 dB aufweisen.

10. System nach Anspruch 9, das auch eine Steuerung (CTR) umfasst, die zum Steuern des Senders (TX) konfiguriert ist, sodass er die Leistungspegelabweichung zwischen dem ersten und dem zweiten elektromagnetischen Signal variiert, und einen Prozessor (PR), der zum Identifizieren der oder mindestens einer elektronischen Vorrichtung (AEL) in der Region von Interesse in Abhängigkeit von einer Variation des Leistungspegels ($P_{IM3L}$, $P_{IM3H}$) des empfangenen Signals (SR) mit der Leistungspegelabweichung ($\Delta$) zwischen dem ersten und dem zweiten elektromagnetischen Signal konfiguriert ist.

**Claims**

1. A method for detecting electronic apparatuses comprising the following steps:

   a) simultaneously transmitting, to the same region of interest (RDI), a first electromagnetic signal (S1) at a first frequency $f_1$ in the radio or microwave domain and a second electromagnetic signal (S2) at a second frequency $f_2$ also in the radio or microwave domain and higher than the first frequency fi; and
   b) receiving an electromagnetic signal (SR) retransmitted by at least one electronic apparatus (AEL) to be detected that is located in the region of interest, corresponding to an intermodulation product of the first and of the second electromagnetic signal;

   **characterised in that** the first and the second electromagnetic signals have, in the region of interest, different power levels, having a deviation ($\Delta$) of at least 10 dB.

2. The method according to claim 1, wherein the first electromagnetic signal (S1) has, in the region of interest, a power level ($P_{f1}$) higher than that ($P_{f2}$) of the second electromagnetic signal (S2), and wherein the received electromagnetic signal has a frequency $f_{IM3L} = 2f_1-f_2$.

3. The method according to claim 1, wherein the first electromagnetic signal has, in the region of interest, a power level ($P_{f1}$) lower than that ($P_{f2}$) of the second electromagnetic signal, and wherein the received electromagnetic signal (SR) has a frequency $f_{IM3H} = 2f_2-f_1$.

4. The method according to any of the preceding claims, wherein step a) comprises a scan of the first and the second frequency, maintaining a fixed frequency deviation between them.

5. The method according to claim 4, also comprising a step c) of identifying the or an electronic apparatus (AEL) in the region of interest (RDI) as a function of a variation in the power level ($P_{IM3L}$, $P_{IM3H}$) of the received signal (SR) during the scan of the first and of the second frequency.

6. The method according to any of the preceding claims, wherein step a) comprises a variation in the power level deviation ($\Delta$) between the first (S1) and the second (S2) electromagnetic signal.

7. The method according to claim 6, also comprising a step c') of identifying the or an electronic apparatus (AEL) in the region of interest (RDI) as a function of a variation in the power level ($P_{IM3L}$, $P_{IM3H}$) of the received signal (SR) with the power level deviation ($\Delta$) between the first (S1) and the second (S2) electromagnetic signal.

8. The method according to any of claims 1 to 3, wherein the power levels ($P_{f1}$, $P_{f2}$) of the first (S1) and of the second (S2) electromagnetic signal and their frequencies are set to values maximising the power level of the signal retransmitted by an electronic apparatus (AEL) of a predefined type and corresponding to an intermodulation product of the first and of the second electromagnetic signal.

9. A system for detecting electronic apparatuses, comprising:

   - at least one transmitter (TX) for simultaneously transmitting, to the same region of interest (RDI), a first electromagnetic signal (S 1) at a first frequency $f_1$ in the radio or microwave domain and a second electromagnetic signal (S2) at a second frequency $f_2$ also in the radio or microwave domain and higher than the first frequency fi;

- at least one receiver (RX) for receiving an electromagnetic signal (SR) retransmitted by at least one electronic apparatus (AEL) to be detected that is located in the region of interest, corresponding to an intermodulation product of the first and of the second electromagnetic signal;

**characterised in that** the transmitter is configured to transmit the first and the second electromagnetic signals such that they have, in the region of interest, different power levels, with a deviation ($\Delta$) of at least 10 dB.

10. The system according to claim 9, also comprising a controller (CTR) configured to control the transmitter (TX) so as to vary the power level deviation between the first and the second electromagnetic signal, and a processor (PR) configured to identify said or at least one electronic apparatus (AEL) in the region of interest as a function of a variation in the power level ($P_{IM3L}$, $P_{IM3H}$) of the received signal (SR) with the power level deviation ($\Delta$) between the first and the second electromagnetic signal.

EP 4 202 471 B1

Figure 1

Fig. 1

11

Figure 2

Fig. 2

Figure 3

Fig. 3

Figure 4

Figure 5

Figure 5

Figure 6

Fig. 6

Figure 7

Fig. 7

## RÉFÉRENCES CITÉES DANS LA DESCRIPTION

**Documents brevets cités dans la description**

- EP 0309350 A
- US 9395434 B
- US 20150253415 A

**Littérature non-brevet citée dans la description**

- Intermodulation Radar for RF Receiver Détections. *Proceedings of the 15th European Radar Conférence,* 26 Septembre 2018
- *Compact Intermodulation Radar for Finding RF Receivers Proceedings of the 16th European Radar Conférence,* 02 Octobre 2019